## Europäisches Patentamt

## European Patent Office

## Office européen des brevets

(11) Publication number: **0 042 484**
A2

(12)

# EUROPEAN PATENT APPLICATION

(21) Application number: 81103565.8

(22) Date of filing: 11.05.81

(51) Int. Cl.³: **H 01 L 33/00**
**H 01 L 21/306, H 01 L 29/06**

(30) Priority: 25.06.80 CA 354753

(43) Date of publication of application:
30.12.81 Bulletin 81/52

(84) Designated Contracting States:
DE FR GB NL

(71) Applicant: NORTHERN TELECOM LIMITED
1600 Dorchester Boulevard, West
Montreal Quebec H3H 1R1(CA)

(72) Inventor: Springthorpe, Anthony John
P.O. Box 96 55 Fortune Street
Richmond Ontario, KOA 2Z0(CA)

(72) Inventor: Look, Christopher Michael
24 E Woodfield Drive
Nepean Ontario K2G 3Y5(CA)

(74) Representative: Wilkinson, Stuart Leslie
Langton House Market Street
Maidenhead, Berkshire SL6 8BE(GB)

(54) High radiance LED's.

(57) In a surface emitting light emitting diode (LED), light propagating in the plane of an active pn junction region (16) is utilized by turning it into the surface emitting direction using a mirror inclined at 45° to the plane of the junction. To form the mirror, a passivating spot (34) is deposited on the semiconductor crystal and the semiconductor surface is anodized, the resulting oxide layer (22) being simultaneously etched away leaving, under a central region of the spot, a mesa (20) having a curved wall (33), the tangent to which is at 45° to the plane of the junction region (16) at its boundary. An acid is selected which both oxidizes the semiconductor and etches away the oxide (22) as it is produced, thereby permitting a continuous and clean process.

Fig-1-

Croydon Printing Company Ltd.

- 1 -

This invention relates to light emitting diodes (LED's) of the surface emitting type and particularly to such LED's in which external quantum efficiency is enhanced.

For a normal "Burrus" or surface emitting light emitting diode (LED), the maximum attainable external quantum efficiency, which is a measure of the conversion of injected current to utilizable optical energy, is about 4%. Since LED emission is galactic, a portion of the generated light propogates along and tends to be guided by the active pn junction before being emitted from the edge of the LED. Such emission is, in fact, the principal form of light emission of edge emitting LED's.

It has been recognized that a portion, at least, of the edge emitted light can be recovered before it leaves the semiconductor and can be combined with the surface emitted light in order to increase the external quantum efficiency of a LED. This has been suggested by A.C. Carter, et al, ("A New Surface Emitting GaInAsP 1.3$\mu$m LED With Up To Threefold Enhancement in External Quantum Efficiency"; papers presented at the International Electron Devices Conference in Washington, December 1979, and published in the Extended Abstracts of the Conference). This publication discloses a structure fabricated using crystallographically selective etches to create facets and retroreflectors in the rear face of a LED. Carter et al, describe a structure which is not circularly symmetric, and in which light propagating in the plane of the active junction in certain directions is turned and is emitted in a direction normal to the junction. However, the arrangement of mirror facets and retroreflectors is complex, resulting, for example, in the redirected light being emitted from a line rather than from a circular spot. In addition, the structure envisages inclined mirror facets located in vertical alignment with the centre of the surface emitting region of the LED. To some extent, the mirrors must attenuate direct and rear-reflected light propagating perpendicularly to the pn junction, this being the main source of generated light for the surface emitting LED.

This invention proposes the use of a non-selective etch to produce a single continuous mirror facet bounding an active region of the LED pn junction. The facet which is inclined at 45° to the plane of the pn junction can be formed using a continuous multiple anodization and etch technique ensuring speed and freedom from contamination. The redirected light produced during operation of such a device is distributed around the edge of the active region so producing a circularly symmetric output light distribution. Moreover, direct and rear-reflected light propagating perpendicularly to the pn junction is not attenuated by intervening mirror facets as occurs in the known prior art device.

An embodiment of the invention will now be described, by way of example, with reference to the accompanying drawings in which:-

Figure 1 shows an enhanced emission surface emitting LED according to the invention; and

Figure 2 shows a stage during the fabrication of the Figure 1 LED.

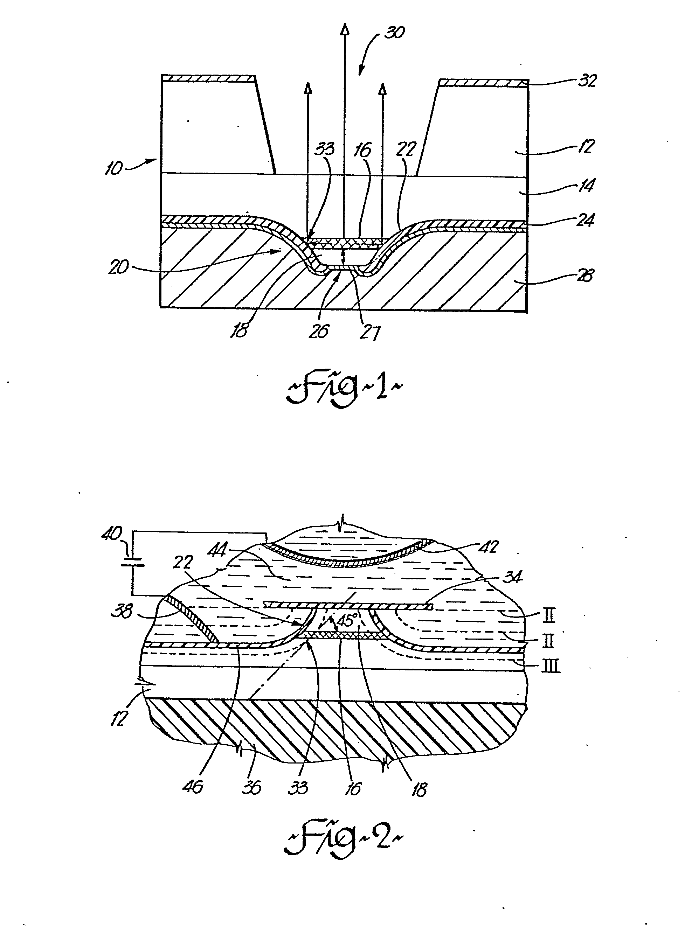

Referring in detail to Figure 1, a LED 10 of the Burrus or surface-emitting type has an n-type GaAs substrate 12, an n-type GaAlAs confining layer 14, an n-type GaAlAs active layer 16, and a p-type GaAlAs second confining layer 18. The combination of these layers is in the shape of a circular-section, truncated conical mesa 20. The mesa has a wall 22 of curved profile, the wall 22 being inclined at 45° to the plane of the active layer 16 at the boundary of the active layer. The mesa 20 and the first confining layer 14 are covered by an insulating silicon dioxide layer 24 except at a window 26 which exposes a contact region at an outer surface of the mesa 20. A CrAu contact layer 27 is vapour deposited through the window 26 and an electroplated layer 28 of gold provides a heat sink.

A gold top contact 32 is vacuum evaporated onto the substrate outer surface 30 and a circular recess 30 is etched into the GaAs immediately opposite the mesa 20, the recess extending to the first confining layer 14.

In operation, when current is passed through the device via negative top contacts 32 and positive bottom contact 27, electron-hole recombination gives rise to light emission in the active layer 16. The first confining layer 14 is only of the order of 5-10 µm, and its energy band gap is higher than that of the active layer 14, so that light propagating upwardly from the active region is not materially absorbed and so is emitted into the recess 30. Supplementing the light emitted directly into the recess 30, rear-directed light incident on the outer surface 23 of the mesa 20 is reflected upwardly through the device and combines with the directly emitted light.

Light propagating generally in the plane of the active region is also internally reflected upwardly towards recess 30. Reflection takes place from a mirror 33 formed at the inclined boundaries of the active layer 16 and immediately adjacent parts of the confining layer 14 and 18. Thus light that would normally be lost in the plane of the active layer is extracted and can be coupled, together with the light emitted perpendicularly to the pn junction, into the end of an optical fibre (not shown) fixed by a refractive index matching epoxy into the recess 30.

Alternatively the fiber can be fixed in a position in which the fiber end and the LED crystal are separated by an air gap. In such a case, operating the LED at high injected current levels causes light to be generated preferentially in the plane of the active layer owing to optical feedback occuring when light is reflected at the crystal/air interfaces. In a conventional surface emitting LED, this superluminescent light, which is especially pronounced in long wavelength LED's, would normally be totally lost. However, the circularly symmetric mirror 33 renders the light utilizable by turning it out of the plane of the pn junction and into the surface-emitting direction.

In describing the formation of the mirror 33, reference is now made to Figure 2 which shows a part of the LED 1 inverted as compared with the representation of Figure 1.

Starting with a GaAs substrate 12, first and second confining layers and the active layer 14, 18, and 16 are grown in one of several well-known processes, for example, liquid phase epitaxy. The exposed surface of the p-type confining layer 18 is then subjected to a $Zn^+$ diffusion step to make the outer 5000 Å strongly p-type.

A passivating layer 34 of silicon dioxide is then vacuum deposited on the zinc diffused surface of the confining layer 18. The passivating layer 34 is then photo-defined into a circular region. Subsequently, the GaAs crystal is held against a Teflon[R] support 36 using an aluminum spring 38 which acts as a probe from the positive terminal of a constant current source 40. The passivated side of the substrate faces a coil of platinum wire 42 suspended within acid 44, the platinum coil 42 being electrically connected to the negative terminal of the constant current source 40.

The acid 44, which is a solution of phosphoric acid having a pH of the order of 2 and a temperature of about 25°C, has a dual function. Firstly, hydroxyl ions are attracted to the exposed confining layer 18, and, under the influence of the driving potential, form an insulating layer 46 consisting of oxides of $Ga_2O_3$ and $As_2O_3$.

However, this oxide layer 46 is soluble in the acid 44 and so dissolves shortly after formation. The constant current source is limited to 50 V in order to avoid dielectric breakdown of the silicon dioxide layer 34. Typically, an anodizing current of about 5 to $10mA/cm^2$ is experienced by the GaAs.

Figure 2 shows an intermediate stage in the anodization/etch process, other stages being shown as broken lines I, II, and III. Since the etching process used is not selective, i.e. it does not follow crystallographic planes, the etched profile of the mesa wall 22 corresponds more-or-less to a quandrant. The anodization and etch process is continued until the etch reaches a depth, (III), at which the boundary of the active layer 16 is at 45° to the plane of the active layer, this being shown by a chain line tangential to the mesa wall 22 at the boundary of active layer 16. A pH value of 2 is selected, since, at this strength, the dissolution of the oxide layer 46, which takes place at the oxide/acid interface is uniform and proceeds at a convenient rate. The rate of oxide layer growth can be adjusted by changing the current after an initial growth period to ensure that the subsequent growth rate is the same as the rate of dissolution. Shortly after the process is commenced, a stable situation is attained where anodization and etch continue at the same rate with an oxide layer of about 1000Å separating the two interfaces. Consequently, the GaAs itself is not etched. The coincident anodization-acid etch has, in addition to the benefit of speed, the merit that it reduces contamination which would occur each time that the crystal were removed from a bath if the anodization and the etch were performed separately.

Although other acid and alkali based systems could be used, phosphoric acid having a pH from 1.5 to 3.5 has proved to be very effective in that:-

(a)   it results in a very uniform anodized layer;

(b)   contamination is more easily prevented;

(c)   it is very easy to fix and maintain a selected etch rate;

(d)   the acid does not change its properties over the etch time.

The important feature of the anodization/etch is that it be non-selective and therefore not determined by crystallographic planes. It appears that normal etches break some crystallographic bonds more readily than others and are consequently dependent on geometrical consideration. Being smaller and under the influence of a driving potential, the oxide ions produced in the anodization process can apparently break bonds easily, irrespective of crystallographic orientation.

Although the embodiment described is limited to a GaAlAs/GaAs system, any LED structure in which light is confined within a waveguide will benefit by incorporation of the 45° circularly symmetric mirror. In essence, waveguiding action occurs in a double heterostructure if the energy band gap of the confining layers is much greater than that of the active layer and if the refractive indexes are less than that of the active layer. Other examples are the GaInAsP/InP and the GaAlSb/GaSb systems. For the GaInAsP/InP quaternary system a pulsed anodization current has been found necessary. A d.c. anodization current forms an oxide on the InP which is insoluble in a phosphoric acid etchant. However a pulsed current appears to form an intermediate compound which is soluble.

It should be mentioned that although a 45° mirror 33 is optimum, a variation of $^{+}_{-}5°$ from this inclination can be permitted without severely attenuating the light turned into the surface emitting direction. In addition, while a circularly symmetric mirror is preferred, the essence of the invention is that the active region or a part of the active region, be bounded by a continuous or near-continuous mirror to redirect light propagating in the active region. Consequently increased external quantum efficiency will result from bounded active regions of other shape.

CLAIMS :  - 1 -

1.  A light emitting diode of the surface emitting type having a pn light emitting planar junction region characterized in that said junction region is at least partly bounded by a reflected surface (33) inclined at substantially 45° to the plane of the junction region whereby light propagating in the plane of the junction region is internally reflected at said reflective surface (33) and subsequently propagates substantially in a surface emitting direction of the LED.

2.  A light emitting diode as claimed in claim 1, further characterized in a semiconductor substrate (12), a first confining layer (14) overlying the substrate, an active layer (16) overlying the first confining layer, and a second confining layer (18) overlying the active layer, the pn junction formed at the junction between one of the confining layers and the active layer (16), the active layer (16), the second confining layer (18) and part at least of the first confining layer (14) forming a truncated conical mesa (20) tapering away from the substrate (12).

3.  A light emitting diode as claimed in claim 1 or 2 further characterized in that the light emitting junction region is bounded totally by said inclined reflected surface (33).

4.  A light emitting diode as claimed in any of claims 1 to 3 further characterized in that the light emitting junction region is circular.

5. A light emitting diode as claimed in any of claims 2 to 4 further characterized in that the mesa (20) has an insulating film (24) extending over its surface except at a central region of an outer surface of the second confining layer (18), said insulating film (24) and said central region having a contact film (27) extending thereover.

6. A light emitting diode as claimed in claim 5 further characterized in that said contact film (27) has plated heatsink metallization (28) extending thereover.

7. A light emitting diode as claimed in any of claims 2 to 6 further characterized in that a recess (30) extends from an outer surface of the substrate (12) to the first confining layer (14), the recess (30) being substantially aligned with the mesa (20).

8. A method of fabricating a surface emitting light emitting diode comprising:-

masking a region at one surface of a semiconductor crystal having a planar light emitting junction extending therethrough parallel to the surface; and

non-selectively etching the crystal around the masked region until a mesa (20) remains having a curved wall (33) inclined substantially at 45° to the plane of a junction at the boundary of the junction region.

9. A method as claimed in claim 8 further characterized in that said non-selective etch is performed by anodizing exposed parts of the semiconductor crystal to produce an oxide surface layer (46), and then dissolving the oxide.

10. A method as claimed in claim 9 further characterized in that a common solution (44) functions both as an electrolyte in the anodization of the crystal surface and as an etchant in the dissolution of the oxide layer (46).

11. A method as claimed in claim 10 further characterized in that an anodizing voltage and solution strength are selected so that etching of said oxide layer (46) marginally lags anodization of the crystal surface.

12. A method as claimed in claims 10 or 11 further characterized in that said common solution (44) is phosphoric acid solution having a pH in the range 1.5 to 3.5.

13. A method as claimed in any of the preceding claims further characterized in depositing an insulating layer (24) over said mesa (20) except at a central region of the mesa top surface and vapour depositing a contact layer (27) over said central region.

14. A method as claimed in claim 13 further characterized in electro-plating a metallized heatsink layer (28) over said contact layer (27).

15. A method as claimed in any of claims 9 to 14 further characterized in that a dc anodizing current is used to anodize the exposed parts of the semiconductor crystal.

16. A method as claimed in any of claims 9 to 14 further characterized in that a pulsed anodizing current is used to anodize the exposed parts of the semiconductor crystal.

0042484

*Fig-1-*

*Fig-2-*